# EUROPEAN PATENT APPLICATION

(11) **EP 4 604 704 A1**
(43) Date of publication of application: **20.08.2025**
(21) Application number: 24192338.2
(22) Date of filing: 01.08.2024
(51) Int. Cl.: H10K 59/80

(54) **DISPLAY APPARATUS**

(30) Priority: 13.02.2024 KR 20240020226
(71) Applicant: LG Display Co., Ltd., Seoul 07336 (KR)
(72) Inventor: KWON, Suchan, 10845 Paju-si, Gyeonggi-do (KR); SHIN, Dongtack, 10845 Paju-si, Gyeonggi-do (KR)
(74) Representative: Viering, Jentschura & Partner mbB Patent- und Rechtsanwälte

(57) **Abstract**

Disclosed is a display apparatus (1000). The display apparatus (1000) according to the present disclosure may include a display panel (PNL) including an active area (AA) and a non-active area (NAA) surrounding the active area (AA), a light emitting element unit (EL) including a plurality of light emitting elements disposed on the active area (AA) of the display panel (PNL), a rigidity reinforcement layer (200) disposed above the display panel (PNL), and a polarization layer (153) disposed on the rigidity reinforcement layer (200).

## Description

### BACKGROUND OF THE INVENTION

### Technical Field of the Invention

The present disclosure relates to a display apparatus, and more particularly, for example, without limitation, to a display apparatus in which durability can be increased.

### Description of the Related Art

Display apparatus are applied to various electronic devices such as a TV, a mobile phone, a laptop PC, and a tablet. To this end, research for developing display apparatus that are thinner, lighter, and have lower power consumption is being continuously conducted.

Examples of display apparatus may include a liquid crystal display (LCD) display device, a plasma display panel (PDP) display device, a field emission display (FED) device, an electro-wetting display (EWD) device, an organic light emitting diode (OLED) display device, etc.

Among display apparatus for displaying various pieces of information as images, the OLED display device includes a plurality of pixel areas arranged in an active area in which an image is displayed and OLEDs disposed to correspond to the plurality of pixel areas. Since the OLED is a self-luminous element for emitting light by itself, the OLED display device has an advantages of a faster response time, higher luminous efficiency and luminance, a wider viewing angle, and superior contrast ratio and color gamut than LCD devices.

The description provided in the description of the related art section should not be assumed to be prior art merely because it is mentioned in or associated with the description of the related art section. The description of the related art section may include information that describes one or more aspects of the subject technology, and the description in this section does not limit the invention.

### SUMMARY OF THE INVENTION

In the related art, an organic light emitting diode display device may include a first substrate on which an organic light emitting diode is disposed, and a second substrate disposed to face the first substrate. The organic light emitting diode includes an organic material that can be easily degraded by moisture, oxygen, etc. Therefore, a frit sealant bonding the first and second substrates and surrounding an edge portion of the organic light emitting diode display device is disposed to seal the organic light emitting diode disposed inside the frit sealant with an air gap.

However, the inventors have recognized that as the first and second substrates are opened, the frit sealant may be separated from the first or second substrate to act as foreign substance in the display device, causing defects. In addition, since the organic light emitting diode disposed between the first and second substrates is sealed through the air gap, there is a limitation to be vulnerable to damage due to insufficient rigidity.

Therefore, one example embodiment of the present disclosure is directed to providing a display device in which durability can be improved by arranging a reinforced substrate at a location relatively close to an active area in which an image is displayed.

One example embodiment of the present disclosure is also directed to providing a display device in which the occurrence of defects caused by the separation between vertically overlapping layers can be prevented by adopting an adhesive member that covers the entire surface of the active area.

One example embodiment of the present disclosure is also directed to providing a display apparatus of which weight can be reduced by arranging the reinforced surface which can increase the rigidity of the display and from which a multi-layer for surface treatment can be omitted.

Objects according to one example embodiment of the present disclosure are not limited to the above-described objects, and other objects and advantages of the present disclosure that are not mentioned can be understood by the following description and will be more clearly understood by the example embodiments of the present disclosure. In addition, it will be able to be easily seen that the objects and advantages of the present disclosure can be achieved by devices and combinations thereof that are described in the claims. According to an aspect of the present disclosure, a display apparatus according to claim 1 is provided. Further embodiments are described in the dependent claims.

A display apparatus according to one example embodiment of the present disclosure may include a display panel including an active area and a non-active area surrounding the active area, a light emitting element unit including a plurality of light emitting elements disposed on the active area of the display panel, a rigidity reinforcement layer disposed above the display panel, and a polarization layer disposed on the rigidity reinforcement layer.

Other detailed matters of the example embodiments are included in the detailed description and the drawings.

According to the example embodiment of the present disclosure, durability can be improved by arranging a reinforced substrate at a location relatively close to an active area in which an image is displayed.

The effects of the present disclosure are not limited to the aforementioned effects, and other effects, which are not mentioned above, will be apparently understood to a person having ordinary skill in the art from the following description.

### BRIEF DESCRIPTION OF THE DRAWINGS

The above and other aspects, features and other advantages of the present disclosure will be more clearly understood from the following detailed description taken in conjunction with the accompanying drawings, in which:
FIG. 1 is a plan view schematically showing a portion of a display apparatus according to one example embodiment of the present disclosure.
FIG. 2 is a cross-sectional view showing one side of the display apparatus of FIG. 1.
FIG. 3 is an enlarged cross-sectional view of area 3 in FIG. 2.
FIG. 4 is a cross-sectional view of the display apparatus shown in FIG. 1 along line 4-4.
FIG. 5 is a cross-sectional view of the display apparatus shown in FIG. 1 along line 5-5.
FIG. 6 is a cross-sectional view of the display apparatus shown in FIG. 1 along line 6-6.
FIG. 7 is a cross-sectional view showing one side of the display apparatus of FIG. 1 according to another example embodiment.
FIG. 8 is an enlarged cross-sectional view of area 8 in FIG. 7.
FIG. 9 is a cross-sectional view of the display apparatus shown in FIG. 1 along line 9-9 according to another example embodiment.
FIG. 10 is a cross-sectional view of the display apparatus shown in FIG. 1 along line 10-10 according to another example embodiment.
FIG. 11 is a cross-sectional view of the display apparatus shown in FIG. 1 along line 11-11 according to another example embodiment.
FIG. 12 is a view showing a viewing angle distance of example embodiments of the present disclosure.
FIG. 13 is a cross-sectional view showing one side of the display apparatus of FIG. 1 according to another example embodiment.
FIG. 14 is an enlarged cross-sectional view of area 14 in FIG. 13.

Throughout the drawings and the detailed description, unless otherwise described, the same drawing reference numerals should be understood to refer to the same elements, features, and structures. The relative size and depiction of these elements may be exaggerated for clarity, illustration, and convenience.

### DETAILED DESCRIPTION OF THE INVENTION

Advantages and features of the present disclosure and methods for achieving them will become clear with reference to example embodiments described below in detail in conjunction with the accompanying drawings. However, the present disclosure is not limited to the example embodiments disclosed below but will be implemented in various different forms, these example embodiments are merely provided to make the disclosure of the present disclosure complete and fully inform those skilled in the art to which the present disclosure pertains of the scope of the present disclosure.

Since shapes, sizes, areas, ratios, angles, numbers, and the like disclosed in the drawings for describing the example embodiments of the present disclosure are illustrative, the present disclosure is not limited to the illustrated items. The same reference number indicates the same components throughout the specification. In addition, in describing the present disclosure, when it is determined that the detailed description of a related known technology may unnecessarily obscure the gist of the present disclosure, detailed description thereof will be omitted. When terms "include," "have," "comprise," "contain," "constitute," "make up of," "formed of," and "consist of' and the like described in the present disclosure are used, other parts may be added unless "only" is used. When a component is expressed in the singular, it includes a case in which the component is provided as a plurality of components unless specifically stated otherwise.

In construing a component, the component is construed as including the margin of error even when there is no separate explicit description.

When the positional relationship is described, for example, when the positional relationship between two parts is described using the term "on", "above", "over", "below", "under", "beside", "beneath", "near", "close to," "adjacent to", "on a side of', "next" or the like, one or more other parts may be positioned between the two parts unless the term "immediately" or "directly" is used.

Spatially relative terms, such as "under," "below," "beneath", "lower," "over," "upper" and the like, may be used herein for ease of description to describe one element or feature's relationship to another element(s) or feature(s) as illustrated in the figures. It will be understood that the spatially relative terms can encompass different orientations of an element in use or operation in addition to the orientation depicted in the figures. For example, if an element in the figures is inverted, elements described as "below" or "beneath" other elements or features would then be oriented "over" the other elements or features. Thus, the exemplary term "below" can encompass both an orientation of below and above. Similarly, the exemplary term "above" or "over" can encompass both an orientation of "above" and "below".

When the temporal relationship is described, for example, when the temporal relationship is described using the term "after," "subsequently," "then," "before," or the like, it may include a nonconsecutive case unless the term "immediately" or "directly" is used.

Although terms such as "first", "second", "A", "B", "(a)", "(b)", and the like are used to describe various components, these components are not limited by these terms. The terms are only used to distinguish one component from another. Therefore, a first component described below may be a second component within the technical spirit of the present disclosure.

In addition, terms, such as first, second, A, B, (a), (b), or the like may be used herein when describing components of the present disclosure. Each of these terminologies is not used to define an essence, order, or sequence of a corresponding component but used merely to distinguish the corresponding component from other components. In the case that it is described that a certain structural element or layer is "connected", "coupled", "adhered" or "joined" to another structural element or layer, it is typically interpreted that another structural element or layer may be "connected", "coupled", "adhered" or "joined" to the structural element or layer directly or indirectly.

The term "at least one" should be understood as including any and all combinations of one or more of the associated listed items. For example, the meaning of "at least one of a first item, a second item, and a third item" denotes the combination of all items proposed from two or more of the first item, the second item, and the third item as well as the first item, the second item, or the third item.

A term "apparatus" used herein may refer to a display apparatus including a display panel and a driver for driving the display panel. Examples of the display apparatus may include a light emitting device, and the like. In addition, examples of the apparatus may include a notebook computer, a television, a computer monitor, an automotive device, a wearable device, and an automotive equipment device, and a set electronic device (or apparatus) or a set device (or apparatus), for example, a mobile electronic device such as a smartphone or an electronic pad, which are complete products or final products respectively including the light emitting device and the like, but embodiments of the present disclosure are not limited thereto.

Like reference numerals generally denote like elements throughout the specification.

A size and a thickness of each component illustrated in the drawing are illustrated for convenience of description, and the present disclosure is not limited to the size and the thickness of the component illustrated.

Features of various example embodiments of the present disclosure can be coupled or combined partially or entirely, and various technological interworking and driving are possible, and the example embodiments may be implemented independently of each other or implemented together in an associated relationship.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning for example consistent with their meaning in the context of the relevant art and should not be interpreted in an idealized or overly formal sense unless expressly so defined herein.

In the aspects of the present disclosure, a source electrode and a drain electrode are distinguished from each other, for convenience of description. However, the source electrode and the drain electrode are used interchangeably. The source electrode may be the drain electrode, and the drain electrode may be the source electrode. Also, the source electrode in any one aspect of the present disclosure may be the drain electrode in another aspect of the present disclosure, and the drain electrode in any one aspect of the present disclosure may be the source electrode in another aspect of the present disclosure.

Hereinafter, a display apparatus according to each example embodiment of the present disclosure will be described with reference to the accompanying drawings.

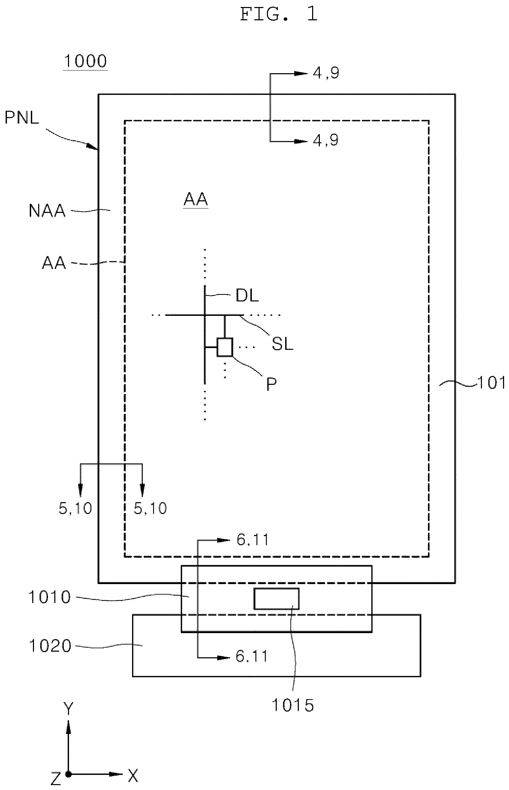

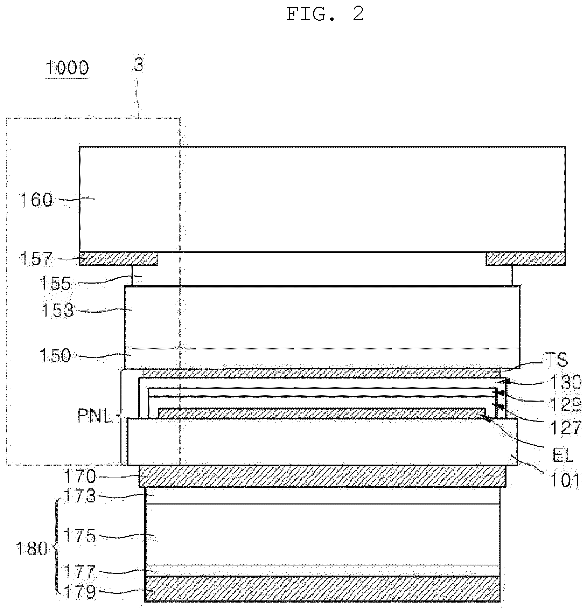

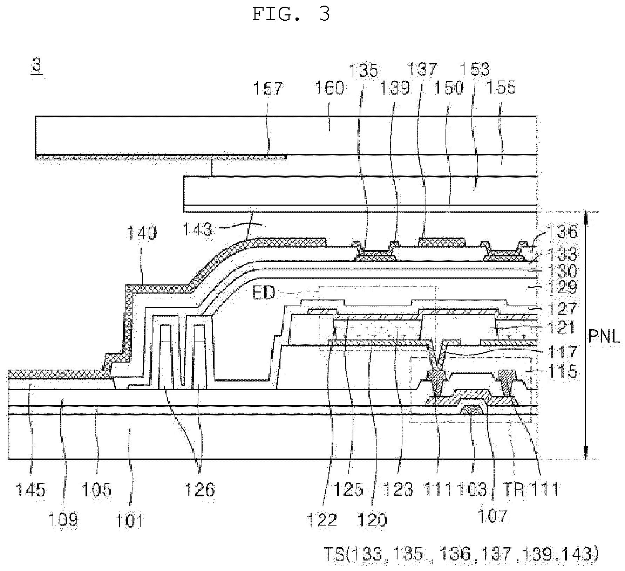

FIG. 1 is a plan view schematically showing a portion of a display apparatus according to one example embodiment of the present disclosure. FIG. 2 is a cross-sectional view showing one side of the display apparatus of FIG. 1. FIG. 3 is an enlarged cross-sectional view of area 3 in FIG. 2. For the convenience of description, in FIG. 1, among various components of the display apparatus 1000, only a display panel PNL, a printed circuit board 1020, a flexible circuit board 1010 and an integrated circuit chip 1015 disposed on the flexible printed circuit board 1010 are illustrated, but components of the display apparatus 1000 of the present disclosure are not limited thereto. Meanwhile, all the components of each display apparatus according to all embodiments of the present disclosure are operatively coupled and configured.

Referring to FIGS. 1 to 3, a display apparatus 1000 according to one example embodiment of the present disclosure may include a display panel PNL, a cover substrate 160 disposed above the display panel PNL, and a back plate unit 180 disposed under the display panel PNL. A polarization layer 153 may be disposed between the display panel PNL and the cover substrate 160, and a protective coating layer 170 may be disposed between the display panel PNL and the back plate unit 180. The display panel PNL and the polarization layer 153 may be bonded through a first adhesive member 150, and the back plate unit 180 may be bonded to the protective coating layer 170 through the second adhesive member 173.

The display panel PNL includes a base substrate 101. The base substrate 101 may contain transparent plastic or glass. In some example embodiments, the base substrate 101 may be made of a flexible plastic material or flexible polymer film. For example, the flexible polymer film may be made of any one of polyimide (PI), polyethylene terephthalate (PET), acrylonitrile-butadiene-styrene copolymer(ABS), polymethyl methacrylate(PMMA), polyethylene naphthalate (PEN), polycarbonate (PC), polyethersulfone (PES), polyarylate (PAR), polysulfone (PSF), cyclic olefin copolymer(COC), triacetylcellulose(TAC), polyvinyl alcohol(PVA), and polystyrene(PS), and the present disclosure is not limited thereto. In a plan view, the base substrate 101 may have a rectangular shape having a long side in a first direction and a short side in a second direction. Alternatively, the base substrate 101 may have a quadrangular shape in which each corner has a rounded shape, but is not limited thereto. The first direction may be, for example, an X-axis direction or horizontal direction of the base substrate 101, and the second direction may be, for example, a Y-axis direction or vertical direction of the first substrate 100.

The display panel PNL may include an active area AA and a non-active area NAA located outside the active area AA. For example, the non-active area NAA is disposed in the vicinity of the active area AA, surrounding the active area AA, or around the active area AA, but not limited thereto.

A plurality of sub-pixels P may be disposed in the active area AA of the base substrate 101. A video or an image may be displayed in the active area AA through the plurality of sub-pixels P. The plurality of sub pixels P is a minimum unit which configures the active area AA and n sub pixels P may form one pixel. Each of the plurality of sub pixels P may emit light having different wavelengths from each other. The plurality of sub pixels may include first to third sub pixels which emit different color light from each other. For example, the plurality of sub pixels P may include a red sub pixel PR which is a first sub pixel, a green sub pixel PG which is a second sub pixel, and a blue sub pixel PB which is a third sub pixel. Further, the plurality of sub pixels SP may also further include a white sub pixel.

For example, the plurality of sub pixels P may include red, green, and blue sub-pixels, in which the red, green, and blue sub-pixels may be disposed in a repeated manner. Alternatively, the plurality of sub pixels P may include red, green, blue, and white sub-pixels, in which the red, green, blue, and white sub-pixels may be disposed in a repeated manner, or the red, green, blue, and white sub-pixels may be disposed in a quad type. For example, the red sub pixel, the blue sub pixel, and the green sub pixel may be sequentially disposed along a row direction, or the red sub pixel, the blue sub pixel, the green sub pixel and the white sub pixel may be sequentially disposed along the row direction. However, in the example embodiment of the present disclosure, the color type, disposition type, and disposition order of the sub-pixels are not limiting, and may be configured in various forms according to light-emitting characteristics, device lifespans, and device specifications.

Meanwhile, the sub-pixels may have different light-emitting areas according to light-emitting characteristics. For example, a sub-pixel that emits light of a color different from that of a blue sub-pixel may have a different light-emitting area from that of the blue sub-pixel. For example, the red sub-pixel, the blue sub-pixel, and the green sub-pixel, or the red sub-pixel, the blue sub-pixel, the white sub-pixel, and the green sub-pixel may each has a different light-emitting area.

Several drivers for driving the plurality of sub-pixels P disposed in the active area AA may be disposed in the non-active area NAA. For example, the driver may include a gate driver, a data driver, a touch driver, and a timing controller, but is not limited thereto.

The non-active area NAA may be an area surrounding the active area AA and may be defined as an area in which a video or image is not displayed. For example, the non-active area NAA may include an upper edge area, a lower edge area, a left edge area, and a right edge area of the display panel PNL. A flexible circuit board 1010 and a printed circuit board 1020 may be disposed on at least one edge of the non-active area NAA.

An integrated circuit chip 1015 may be disposed on the flexible printed circuit board 1010. The flexible circuit board 1010 may have one side coupled to the base substrate 101 and the other side coupled to the printed circuit board 1020 to provide power and various signals for driving the light emitting element unit supplied from the printed circuit board 1020 to the active area AA of the base substrate 101. For example, various signals may include a high potential voltage, a low potential voltage, a scan signal, a data signal, a touch detection signal, etc.

The printed circuit board 1020 may supply signals to the integrated circuit chip 1015 disposed on the flexible printed circuit board 1010. Various components for supplying various signals to the integrated circuit chip 1015 may be disposed on the printed circuit board 1020. In FIG. 1, although one flexible circuit board 1010 and one printed circuit board 1020 are shown, the present disclosure is not limited thereto. For example, a plurality of flexible circuit boards 1010 and a plurality of printed circuit boards 1020 may be disposed at an edge of one side of the base substrate 101.

Referring to FIG. 1, a plurality of data lines DL and a plurality of scan lines SL may be disposed in the active area AA of the base substrate 101. Each of the plurality of data lines DL may be disposed to intersect each of the plurality of scan lines SL. The sub-pixel P can be defined by the data line DL and the scan line SL that intersect each other, and the plurality of sub-pixels P may be disposed in the active area AA. For example, one sub-pixel P may be electrically connected to the gate line and the data line.

One scan line SL extends in the first direction of the base substrate 101. Each of the plurality of scan lines SL may be disposed to be spaced apart from each other in the second direction intersecting the first direction. One data line DL extends in the second direction. Each of the plurality of data lines DL may be disposed to be spaced apart from each other in the first direction intersecting the second direction. The first direction may be, for example, the X-axis direction or horizontal direction of the base substrate 101, and the second direction may be, for example, the Y-axis direction or vertical direction of the first substrate 100.

The plurality of sub-pixels P disposed on the active area AA may form the arrangement in a matrix manner (M*N, in which M and N are natural numbers) on the active area AA of the base substrate 101. A light emitting element may be located in each sub-pixel P to emit light of different colors. For example, the light emitting element may emit light of red, green, or blue, but is not limited thereto.

Referring to FIGS. 2 and 3, the base substrate 101 may include a transistor TR for driving the sub-pixel, a light emitting element unit EL, and a touch sensing unit TS. The base substrate 101 may include a first surface and a second surface facing the first surface. Circuit elements including the transistor TR may be disposed on a first surface of the base substrate 101, and the protective coating layer 170 may be disposed on the second surface on which the transistor TR is not disposed.

The transistor TR may include a gate electrode 103, a gate insulating layer 105, a semiconductor layer 107, and source/drain electrodes 111. The gate insulating layer 105 may be disposed between the gate electrode 103 and the semiconductor layer 107. FIG. 3 shows that the transistor TR has a bottom gate structure, but the present disclosure is not limited thereto. For example, the transistor TR may have a top gate structure or a double gate structure.

The gate electrode 103 may be formed of a single layer or multiple layers made of any one of molybdenum (Mo), aluminum (Al), chromium (Cr), gold (Au), titanium (Ti), nickel (Ni), neodymium (Nd), and copper (Cu), or an alloy thereof.

The semiconductor layer 107 may be made of an oxide semiconductor or a silicon-based semiconductor material. For example, the semiconductor layer 107 may include a transparent oxide semiconductor material such as indium gallium-zinc-oxide (IGZO) or indium-zinc-oxide (IZO). In addition, the semiconductor layer 107 may include a low-temperature growth silicon semiconductor material. The semiconductor layer 107 may include a channel area and source/drain areas disposed at both sides with the channel area therebetween. The gate insulating layer 105 may be formed of a single layer or multiple layers of silicon oxide (SiOₓ) or silicon nitride (SiNₓ), but is not limited thereto. For example, the gate insulating layer 105 may be formed by inorganic film in a single layer or in multiple layers, for example, the inorganic film in a single layer may be a silicon oxide (SiOx) film or a silicon nitride (SiNx) film, and inorganic films in multiple layers may formed by alternately stacking one or more silicon oxide (SiOx) films, one or more silicon nitride (SiNx) films, and one or more amorphous silicon (a-Si), but the present disclosure is not limited thereto.

A buffer layer containing an insulating material that reduces or prevents the permeation of moisture or impurities through the base substrate 101, and a light blocking layer disposed to block the external light incident on the semiconductor layer 107 may be included between the base substrate 101 and the gate electrode 103.

The light blocking layer may be disposed on the base substrate 101. The light blocking layer blocks light which is incident to the semiconductor layer 107 of the plurality of transistors to minimize a leakage current. For example, the light blocking layer is disposed below the semiconductor layer 107 of the driving transistor DT to block light incident onto the semiconductor layer 107. If light is irradiated onto the semiconductor layer 107, a leakage current is generated, which deteriorates the reliability of the driving transistor DT. Accordingly, the light blocking layer blocks which blocks the light is disposed on the base substrate 101 to improve the reliability of the transistor. The light blocking layer may be configured by an opaque conductive material such as copper (Cu), aluminum (Al), molybdenum (Mo), nickel (Ni), titanium (Ti), chrome (Cr), or an alloy thereof, but is not limited thereto.

The buffer layer may be disposed on the light blocking layer. The buffer layer may reduce permeation of moisture or impurities through the base substrate 101. For example, the buffer layer may be configured by a single layer, a double layer or more layers of silicon oxide (SiOx) or silicon nitride (SiNx), but is not limited thereto. For example, the buffer layer may be formed by inorganic film in a single layer or in multiple layers, for example, the inorganic film in a single layer may be a silicon oxide (SiOx) film or a silicon nitride (SiNx) film, and inorganic films in multiple layers may formed by alternately stacking one or more silicon oxide (SiOx) films, one or more silicon nitride (SiNx) films, and one or more amorphous silicon (a-Si), but the present disclosure is not limited thereto. However, the buffer layer may be omitted depending on a type of base substrate 101 or a type of the driving transistor DT, but is not limited thereto.

An interlayer insulating layer 109 may be disposed on the gate electrode 103. The source/drain electrodes 111 passing through the interlayer insulating layer 109 and connected to the source/drain areas of the semiconductor layer 107 may be disposed. The source/drain electrodes 111 may be disposed to cover a portion of a top surface of the interlayer insulating layer 109.

A planarization layer 115 may be disposed on the interlayer insulating layer 109 and the source/drain electrodes 111. The planarization layer 115 may be formed of a single layer or multiple layers. The planarization layer 115 may planarize a step caused by a lower circuit element including the transistor TR. The planarization layer 115 may contain an organic insulating material such as an acryl resin, an epoxy resin, a phenolic resin, a polyamide resin, or a polyimide resin. However, the present disclosure is not limited thereto and the planarization layer 115 may contain an organic insulating material capable of planarizing the step.

The planarization layer 115 may include a contact hole 117 passing through the planarization layer 115 while exposing a portion of a surface of one of the source/drain electrodes 111 of the transistor TR. The contact hole 117 may also be referred to as a pixel contact hole.

The light emitting element unit EL may be disposed on the planarization layer 115. The light emitting element unit EL may include an organic light emitting diode ED including a first electrode 120, an organic light emitting layer 123, and a second electrode 125, and a bank 121 provided with a bank hole 122. A first electrode 120 of the organic light emitting element ED may also be referred to as an anode electrode or a pixel electrode, and a second electrode 125 thereof may also be referred to as a cathode electrode or an opposing electrode.

The first electrode 120 may be disposed on the planarization layer 115. For example, the first electrode 120 may extend to the contact hole 117 and may be in contact with the source/drain electrodes 111 of which surface is exposed by the contact hole 117. A portion of the first electrode 120 extending to the contact hole 117 may be a contact electrode. Therefore, the first electrode 120 may be electrically connected to the transistor TR.

The first electrode 120 may include a transparent metal oxide such as indium-tin-oxide (ITO) or indium-zinc-oxide (IZO). Alternatively, the first electrode 120 may include a single-layer or multilayered structure including a reflective metal film made of silver (Ag), aluminum (Al), gold (Au), nickel (Ni), chromium (Cr), and compounds thereof, but is not limited thereto.

The bank 121 provided with the bank hole 122 may be disposed on the planarization layer 115. The bank 121 may partition each sub-pixel P (see FIG. 1). To this end, the bank 121 may cover an edge of the first electrode 120. Therefore, the bank 121 can prevent light of different colors from being output to adjacent sub-pixels by being mixed. For example, the bank 121 may be configured by a black bank having high light absorptance to suppress color mixture between adjacent sub pixels. For example, the bank 121 may include an organic insulating film such as polyimide or an epoxy, but not limited thereto.

The bank hole 122 may expose a portion of the first electrode 120. The exposed portion of the first electrode 120 may become an emitting area. The organic light emitting layer 123 may be disposed on the first electrode 120. In one example, the organic light emitting layer 123 may contain an organic material that emits light of different colors for each sub-pixel. For example, the organic light emitting layer 123 may emit light of one color among red, green, blue, and white, but is not limited thereto. In another example, the organic light emitting layer 123 may be made of an organic material that emits white light and may display one of red, green, or blue by a color filter.

In one example embodiment, the organic light emitting layer 120 may be formed to cover the first electrode 120 and a portion of a side surface of the bank 121. In another example embodiment, the organic light emitting layer 120 may extend throughout the entire surface of the active area AA to cover the exposed surfaces of the first electrode 120 and the bank 121.

The organic light emitting layer 123 may include a stack structure including a hole transporting layer HTL, an emission material layer EML, an electron transporting layer ETL, a hole blocking layer HBL, a hole injecting layer HIL, an electron blocking layer EBL, and an electron injecting layer EIL. The emission material layer EML of the organic light emitting layer 123 may emit light through recombination of holes injected from the first electrode 120 and electrons injected from the second electrode 125.

The second electrode 125 may be disposed on the organic light emitting layer 123. The second electrode 125 may be formed to cover the organic light emitting layer 123. The second electrode 125 may be commonly formed on the plurality of sub-pixels P. The second electrode 125 may include a transparent metal oxide such as indium-tin-oxide (ITO) or indium-zinc-oxide (IZO). Alternatively, the second electrode 125 may include a single-layer or multilayered structure including a reflective metal film made of silver (Ag), aluminum (Al), gold (Au), nickel (Ni), chromium (Cr), and compounds thereof, but not limited thereto.

Meanwhile, depending on bottom emission type or top emission type of the display apparatus, one of the first electrode and the second electrode may include a single layer or multiple layers including an opaque conductive material having a relatively high reflection efficiency, whereas the other of the first electrode and the second electrode may include transparent conductive material or translucent conductive material, but not limited thereto.

For example, the opaque conductive material may include a material having a relatively low work function such as aluminum (Al), silver (Ag), copper (Cu), lead (Pb), molybdenum (Mo), titanium (Ti) and an alloy thereof. for example, the transparent conductive material may include indium tin oxide (ITO) or indium zinc oxide (IZO) and the like, and the present disclosure is not limited thereto.

Encapsulation layers 127, 129, and 130 may be disposed on the light emitting element unit EL. The encapsulation layers 127, 129, and 130 may protect the light emitting element EL and the transistor TR from external oxygen or moisture. The encapsulation layers 127, 129, and 130 may cover the active area AA (see FIG. 1) and extend to the non-active area NAA (see FIG. 1) surrounding the active area AA. The encapsulation layers 127, 129, and 130 may include a multilayered structure in which the first encapsulation layer 127, the second encapsulation layer 129, and the third encapsulation layer 130 are stacked.

The first encapsulation layer 127 may be disposed to cover the second electrode 125 of the light emitting element unit EL. The first encapsulation layer 127 may contain an insulating material. For example, the first encapsulation layer 127 may contain at least one inorganic insulating material among silicon nitride (SiNₓ), silicon oxide (SiOₓ), and silicon oxynitride (SiON).

The second encapsulation layer 129 may cover the first encapsulation layer 127 and have a sufficient thickness to have a flat surface. The second encapsulation layer 129 can prevent foreign substances from permeating the light emitting element unit EL or the transistor TR. The second encapsulation layer 129 may contain an insulating material. For example, the second encapsulation layer 129 may include at least one material among an epoxy, polyimide, polyethylene, or acrylate.

The third encapsulation layer 130 may be disposed on the second encapsulation layer 129. The third encapsulation layer 130 may cover the second encapsulation layer 129 and contain an inorganic insulating material. For example, the third encapsulation layer 130 may contain at least one material among silicon nitride (SiNₓ), silicon oxide (SiOₓ), and silicon oxynitride (SiON).

Meanwhile, the encapsulation layers are not limited to three layers, for example, n layers alternately stacked between inorganic encapsulation layer and organic encapsulation layer (where n is an integer greater than 3) may be included.

The base substrate 101 may include a dam structure 126 disposed between the active area and a pad area in which a pad electrode 145 is disposed. The dam structure 126 is used to prevent the second encapsulation layer 128 from overflowing to the pad area. For example, the dam structure 126 may include a structure in which a first dam formed coplanarly with the planarization layer 115 and a second dam formed coplanarly with the bank 121 are stacked vertically. For example, the first dam may be formed of the same material as the planarization layer 115, but is not limited thereto. For example, the second dam may be formed of the same material as the bank 121, but is not limited thereto.

The first encapsulation layer 127 may extend to the dam structure 126 portion of the display panel PNL to cover side surfaces of each of the planarization layer 1 15and the dam structure 126.

The touch sensing unit TS may be disposed on the third encapsulation layer 130. The touch sensing unit TS may include a touch buffer film 133, a touch sensor disposed on the touch buffer film 133 and including a plurality of touch electrodes 135 and 137 and a plurality of bridge electrodes 139, a touch interlayer insulation layer 136, and a touch protective film 143.

The touch interlayer insulating layer 136 may be disposed between the plurality of touch electrodes 135 and 137 and the plurality of bridge electrodes 139 to insulate the plurality of touch electrodes 135 and 137 and the plurality of bridge electrodes 139. The touch interlayer insulating layer 136 may include a contact hole exposing a portion of a surface of the bridge electrode 139. In the plurality of touch electrodes 135 and 137, adjacent touch electrodes may be electrically connected through contact holes.

The plurality of touch electrodes 135 and 137 may include the plurality of first touch electrodes 135 and the plurality of second touch electrodes 137. The plurality of first touch electrodes 135, the plurality of second touch electrodes 137, and the plurality of bridge electrodes 139 may be located at different layers. For example, the plurality of first touch electrodes 135 may be disposed to be spaced apart from each other in the first direction of the base substrate 101, and the plurality of second touch electrodes 137 may be disposed to be spaced apart from each other in the second direction of the base substrate 101. The second touch electrode 137 may be disposed between the plurality of first touch electrodes 135 disposed adj acent to each other. The plurality of first touch electrodes 135 disposed adj acent to each other may be electrically connected through the bridge electrode 139 located at a different layer.

Each of the plurality of touch electrodes 135 and 137 may be electrically connected to the pad electrode 145 through a plurality of touch link lines 140 disposed outside the active area AA. The touch link line 140 may be disposed coplanarly with the plurality of touch electrodes 135 and 137, but is not limited thereto. The touch link line 140 may extend along the exposed surface of the touch interlayer insulating layer 136 and may be connected to the pad electrode 145.

The touch protective film 143 may be disposed to cover the plurality of touch electrodes 135 and 137. The touch protection layer 143 may include an organic insulating material.

The polarization layer 153 may be disposed above the touch protective film 143. The polarization layer 153 can suppress external light reflection and change a polarization state of light emitted from the light emitting element unit EL. The polarization layer 153 may be bonded to the display panel PNL through the first adhesive member 150. For example, the first adhesive member 150 may include a pressure sensitive adhesive (PSA).

The cover substrate 160 may be disposed on the polarization layer 153. The cover substrate 160 may cover the display panel PNL including the base substrate 101 to protect the transistor TR, the light emitting element unit EL, and circuit elements that are disposed on the base substrate 101. The cover substrate 160 may also be referred to as a cover window, a window cover, or a cover glass.

The cover substrate 160 may include a glass substrate. An optical adhesive member 155 may be further included between the polarization layer 153 and the cover substrate 160. The optical adhesive member 155 may include an optically clear adhesive film (OCA), but not limited thereto.

A front face of the cover substrate 160 may be a light emission face through which light emitted from the light emitting element unit EL is emitted to the outside. The user may view the video or image displayed from the display panel PNL through the front face of the cover substrate 160. A plurality of functional layers such as an anti-fingerprint coating layer, an anti-reflection layer, and an anti-glare layer may be disposed in a multilayered structure on the front face of the cover substrate 160, but not limited thereto.

A rear face facing the front face of the cover substrate 160 may be a light incident surface on which the light emitted from the light emitting element unit EL is incident. A light blocking pattern 157 may be disposed on the rear face of the cover substrate 160. The light blocking pattern 157 serves to prevent circuit patterns disposed on the non-active area (NAA) from being visible to the user. For example, the circuit patterns disposed on the non-active area (NAA) may include metal lines, pad electrodes, integrated circuit chips, flexible circuit boards, or printed circuit boards, but not limited thereto.

To this end, the light blocking pattern 157 may be located on the non-active area (NAA) and may have a closed loop shape surrounding four edge portions of the rear face of the cover substrate 160. For example, the light blocking pattern 157 may be disposed to include an upper edge area, a lower edge area, a left edge area, and a right edge area. The light blocking pattern 157 may include a film mixed with an opaque pigment. For example, the opaque pigment may include carbon black or titanium black, but is not limited thereto.

Referring back to FIG. 2, the protective coating layer 170 may be disposed on a second surface of the base substrate 101. In a process such as a deposition process for forming the transistor TR (see FIG. 3) on the first surface of the base substrate 101, microscopic damage to the second surface may occur. A portion of the second surface of the base substrate 101 in which microscopic damage remains may have degraded rigidity compared to a portion in which no damage has occurred. As a result, defects such as damage to the base substrate 101 caused by a small impact may occur. Therefore, the damaged portion of the second surface of the base substrate 101 may be removed through an etching process, and the protective coating layer 170 may be disposed on a surface of the removed second surface. The protective coating layer 170 can increase the rigidity of the base substrate 101. The protective coating layer 170 may be formed by being coated with an opaque insulating material. For example, the protective coating layer 170 may contain a black resin, but is not limited thereto.

The back plate unit 180 may be disposed on the second surface of the base substrate 101 on which the protective coating layer 170 is disposed. The back plate unit 180 may reinforce the rigidity of the base substrate 101, have a heat dissipation function, and absorb an external impact. To this end, the back plate unit 180 may include a multilayered structure of a second adhesive member 173, an impact absorption layer 175, a third adhesive member 177, and a heat dissipation layer 179, but is not limited thereto.

The second adhesive member 173 may attach the impact absorption layer 175 to the protective coating layer 170. The second adhesive member 173 may include a pressure-sensitive adhesive (PSA). The impact absorption layer 175 may be made of a foam material, thereby mitigating the external impact. For example, the impact absorption layer 175 may include polyurethane (PU), but is not limited thereto. The impact absorption layer 175 can prevent the damage to the display panel PNL due to the external impact.

The heat dissipation layer 179 may be attached to the impact absorption layer 175 through the third adhesive member 177. The second adhesive member 173 may include a pressure-sensitive adhesive (PSA). The heat dissipation layer 179 may dissipate heat generated inside the display panel PNL to the outside when the light emitting element unit EL is driven. The heat dissipation layer 179 may contain a metal material having high thermal conductivity to serve as a grounding member of the circuit elements disposed on the display panel PNL. In addition, the heat dissipation layer 179 may include a relatively rigid metal material to reinforce the rigidity of the display panel PNL. For example, the heat dissipation layer 179 may contain aluminum (Al), but is not limited thereto.

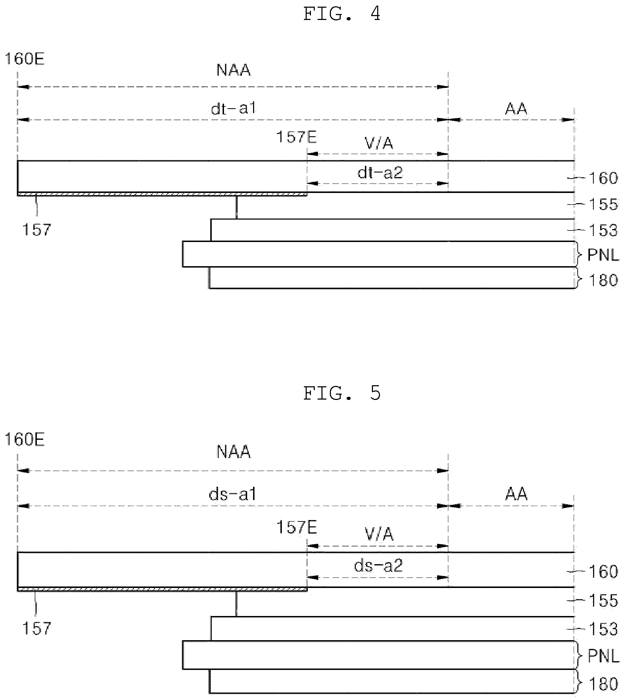

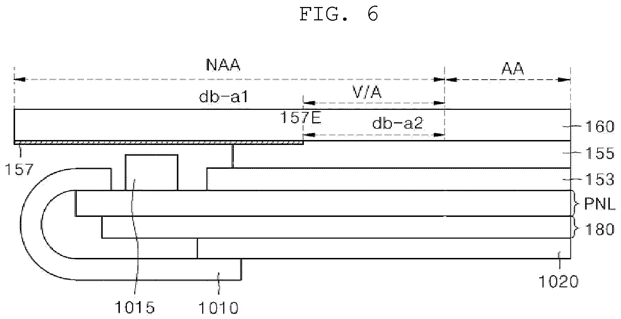

FIG. 4 is a cross-sectional view of the display apparatus shown in FIG. 1 along line 4-4. FIG. 5 is a cross-sectional view of the display apparatus shown in FIG. 1 along line 5-5. In addition, FIG. 6 is a cross-sectional view of the display apparatus shown in FIG. 1 along line 6-6. In FIGS. 4 to 6, the display panel PNL and the back plate unit 180 are schematically shown for convenience of description.

Referring to FIGS. 4 to 6 and FIG. 1 together, the display apparatus 1000 may include the active area AA and the non-active area NAA surrounding the outside of the active area AA. The non-active area NAA may be first areas dt-a1, ds-a1, and db-al between an outermost end portion 160E of the cover substrate 160 and the boundary of the active area AA. The first areas dt-a1, ds-a1, and db-al of the non-active area NAA may be the first area dt-a1 (see FIG. 4) at the upper edge of the display panel PNL, the first area ds-a1 (see FIG. 5) at the left and right edges thereof, and the first area db-al (see FIG. 6) at the lower edge of the display panel PNL.

The non-active area (NAA) may be located to overlap a view area V/A. The view area V/A may be an area visible to the user. The active area AA may be an area in which a video or image is displayed. The light blocking pattern 157 surrounding four outer edge portions of the cover substrate 160 may be disposed to form the view area V/A. The view area V/A may be located between an inner end portion 157E of the light blocking pattern 157 disposed close to the boundary of the active area AA and the boundary of the active area AA. For example, the view area V/A may have first separation distances dt-a2, ds-a2, and db-a2 between the inner end portion 157E of the light blocking pattern 157 and the boundary of the active area AA. The first separation distances dt-a2, ds-a2, and db-a2 of the view area V/A may be the first separation distance dt-a2 (see FIG. 4) at the upper edge of the display panel PNL, the first separation distance ds-a2 (see FIG. 5) at the left and right edges of the display panel PNL, and the first separation distance db-a2 (see FIG. 6) at the lower edge of the display panel PNL. For example, in a second direction of the base substrate 101, a length of the first area dt-a1 at the upper edge of the display panel PNL is equal to a sum of the first separation distance dt-a2 at the upper edge of the display panel PNL and a length of the light blocking pattern 157 (see FIG. 4). For example, in a first direction of the base substrate 101, a length of the first area ds-a1 at the left and right edges of the display panel PNL is equal to a sum of the first separation distance ds-a2 at the left and right edges of the display panel PNL and a length of the light blocking pattern 157 (see FIG. 5). For example, in a second direction of the base substrate 101, a length of the first area db-al at the lower edge of the display panel PNL is equal to a sum of and the first separation distance db-a2 at the lower edge of the display panel PNL and a length of the light blocking pattern 157(see FIG. 6). However, the present disclosure is not limited thereto.

In the display apparatus according to one example embodiment of the present disclosure, the cover substrate 160 may be located on an uppermost layer of the display apparatus 1000. Since the cover substrate 160 contains glass, a functional layer for surface treatment of the cover substrate 160 is required. For example, a plurality of functional layers such as an anti-fingerprint coating layer, an anti-reflection layer, and an anti-glare layer may be disposed in a multilayered structure on the front face of the cover substrate 160. However, to form the functional layers in a multi-layer, separate processes are required, and manufacturing costs increase. In addition, foreign substance, etc. may be generated during each process for forming the multilayered structure to act as defects. As a result, the video or image quality of the display apparatus can be degraded.

Therefore, there is a need for a structure capable of degrading the video or image quality of the display apparatus while reducing manufacturing costs.

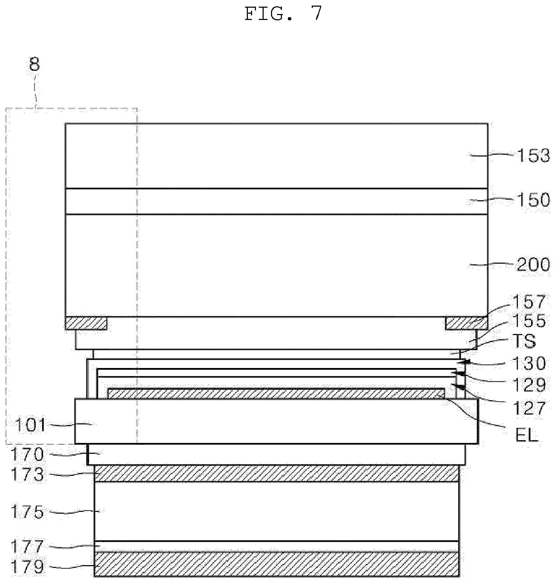

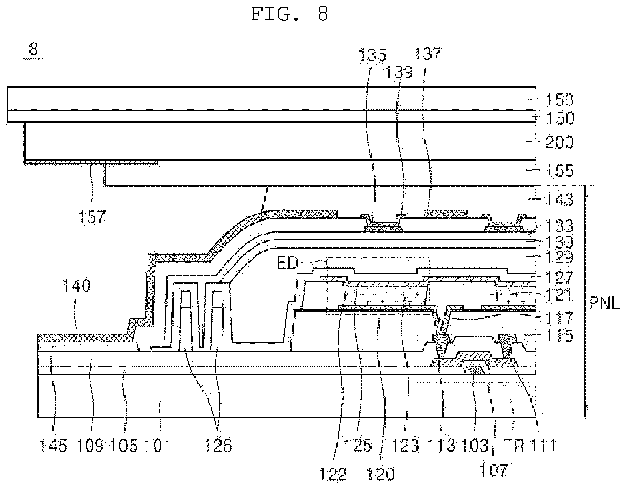

FIG. 7 is a cross-sectional view showing one side of the display apparatus of FIG. 1 according to another example embodiment. FIG. 8 is an enlarged cross-sectional view of area 8 in FIG. 7. In FIGS. 7 and 8, since the same components as those in FIGS. 2 and 3 have the same reference numerals, overlapping descriptions thereof will be omitted or briefly described, and different parts will be described.

Referring to FIGS. 7 and 8, a display apparatus according to another example embodiment of the present disclosure may have a rigidity reinforcement layer 200 disposed on the display panel PNL. The polarization layer 153 may be disposed above the rigidity reinforcement layer 200. The display panel PNL may include the light emitting element unit EL and the touch sensing unit TS that are disposed on the base substrate 101 provided with the transistor TR. The light emitting element unit EL may be sealed with the encapsulation layer including the first encapsulation layer 127, the second encapsulation layer 129, and the third encapsulation layer 130. The touch sensing unit TS may be disposed on the encapsulation layers 127, 129, and 130. The back plate unit 180 may be disposed under the display panel PNL.

As the polarization layer 153 is disposed on the rigidity reinforcement layer 200, the polarization characteristics of the light passing through the rigidity reinforcement layer 200 may change while passing through the polarization layer 153. In addition, the polarization layer 153 can prevent the degradation of visibility in the active area AA due to reflection of external incident light from the metal lines disposed on the display panel PNL. For example, the polarization layer 153 may be a quarter-wavelength retardation film, but not limited thereto.

When the external light is incident on the display apparatus in which the polarization layer 153 is disposed on the rigidity reinforcement layer 200 according to the example embodiment of the present disclosure, only light matching an axis direction of the polarization layer 153, such as a first axis direction, may pass through the polarization layer 153. The first axis direction may be the X-axis direction. When light aligned in the first axis direction of the polarization layer 153 passes through the polarization layer 153, a phase of the light may be changed by 45 degrees and incident on the rigidity reinforcement layer 200.

The light passing through the rigidity reinforcement layer 200 may be reflected from the metal lines disposed on the display panel PNL to re-pass through the rigidity reinforcement layer 200 and may be emitted toward the polarization layer 153. The rigidity reinforcement layer 200 may include an optical layer in which a phase difference does not occur when light is transmitted.

The light re-incident on the polarization layer 153 without any change in phase while passing through the rigidity reinforcement layer 200 may have a second axis direction different from the first axis direction due to a change in phase in the polarization layer 153. For example, the second axis direction may be the Y-axis direction. Therefore, since the light in the second axis direction differs from the axis direction of the polarization layer 153, the light is not emitted to the outside, thereby preventing the light from being visible to the user in the active area AA. Therefore, it is possible to prevent the degradation of visibility in the active area AA. In another example, the first axis direction may be the Y-axis direction, and the second axis direction may be the X-axis direction.

Here, when the rigidity reinforcement layer 200 includes an optical layer that changes the phase, the phase of light passing through the rigidity reinforcement layer 200 may be changed, and the phase of light may be re-changed in the polarization layer 153. In this case, as the light aligned with the polarization layer 153 in the axis direction is emitted to the outside, the visibility in the active area AA can be degraded.

Therefore, the rigidity reinforcement layer 200 may include an optical layer in which the phase difference does not occur when light is transmitted. For example, the rigidity reinforcement layer 200 may include the optical layer in which the phase difference does not occur when the light emitted from the light emitting element unit EL of the display panel PNL, the light incident from the outside, or the reflected light inside the display panel PNL is transmitted.

When the polarization layer 153 is disposed under the rigidity reinforcement layer 200, an additional surface treatment process for increasing wear resistance may be required on the surface of the rigidity reinforcement layer 200. For example, a hard coating layer may be formed on the surface of the rigidity reinforcement layer 200. When the additional surface treatment processes are performed, manufacturing costs can increase.

In contrast, when the polarization layer 153 is disposed on the rigidity reinforcement layer 200 according to the example embodiment of the present disclosure, the additional surface treatment process for the rigidity reinforcement layer 200 can be omitted. Therefore, it is possible to reduce the manufacturing costs of the rigidity reinforcement layer 200.

The rigidity reinforcement layer 200 may contain tempered glass, polycarbonate (PC), or polymethyl methacrylate (PMMA). The rigidity reinforcement layer 200 may have the thickness ranging from 0.2 mm to 0.5 mm to secure the rigidity of the display apparatus. For example, the rigidity reinforcement layer 200 may have the thickness ranging from 0.25 mm to 0.45 mm, but not limited thereto.

The rigidity reinforcement layer 200 may be bonded to the display panel PNL through the optical adhesive member 155. The optical adhesive member 155 may include an optically clear adhesive film (OCA) or an optically clear adhesive resin (OCR). When the optically clear adhesive film (OCA) or the optically clear adhesive resin (OCR) is applied as the optical adhesive member 155, the manufacturing costs of the display apparatus can be reduced.

One surface of the optical adhesive member 155 may be in contact with a top surface of the touch protection film 143 of the touch sensing unit TS, and the other surface may be disposed in contact with a back surface of the rigidity reinforcement layer 200. The rigidity reinforcement layer 200 may be attached to the entire area of the display panel PNL through the optical adhesive member 155, thereby increasing the rigidity of the display apparatus.

The rigidity reinforcement layer 200 may include a first surface, which is a light incident surface on which the light emitted from the light emitting element unit EL is incident, and a second surface, which faces the first surface and is a light emission surface from which the incident light is emitted to the outside. For example, the first surface of the rigidity reinforcement layer 200 may be located to face the light emitting element unit EL, and the second surface may be located to face the polarization layer 153.

The light blocking pattern 157 may be disposed on an edge portion of the first surface of the rigidity reinforcement layer 200. The light blocking pattern 157 can prevent circuit patterns disposed on the non-active area (NAA) from being visible to the user. For example, the circuit patterns disposed on the non-active area (NAA) may include metal lines, pad electrodes, integrated circuit chips, flexible circuit boards, or printed circuit boards, but not limited thereto.

To this end, the light blocking pattern 157 may be located on the non-active area (NAA) of the rigidity reinforcement layer 200. The light blocking pattern 157 may have a closed loop shape surrounding four sides of the first surface of the rigidity reinforcement layer 200. For example, the light blocking pattern 157 may be disposed to cover the upper edge area, lower edge area, left edge area, and right edge area of the rigidity reinforcement layer 200. The light blocking pattern 157 may include a film mixed with an opaque pigment. For example, the opaque pigment may include carbon black or titanium black, but is not limited thereto.

The polarization layer 153 may be disposed on the second surface of the rigidity reinforcement layer 200. The polarization layer 153 may be bonded to the second surface of the rigidity reinforcement layer 200 through the first adhesive member 150. For example, the first adhesive member 150 may include a pressure-sensitive adhesive (PSA), but not limited thereto.

According to the example embodiment of the present disclosure, the rigidity reinforcement layer 200 may be disposed under the polarization layer 153. The polarization layer 153 may be disposed on the uppermost layer of the display apparatus. Therefore, a multilayered structure such as an anti-fingerprint coating layer, an anti-reflection layer, and an anti-glare layer, which are functional layers for surface treatment, can be omitted from the rigidity reinforcement layer 200. Therefore, it is possible to simplify the process of manufacturing the display apparatus and reduce manufacturing costs. In addition, a plurality of processes for forming the multilayered structure can be omitted, thereby preventing the generation of foreign substance during each process. Therefore, the video or image quality of the display apparatus can be maintained.

A three-sided borderless design can be implemented as the rigidity reinforcement layer 200 is disposed relatively closer to the display panel PNL and the polarization layer 153 protrudes more than the outermost portion 200E of the rigidity reinforcement layer 200. Therefore, compared to a display apparatus to which a bezel is applied, a relatively larger active area AA can be provided to the user. As a result, it is possible to further increase the user's sense of immersion in the video or image.

In addition, as the rigidity reinforcement layer 200 is disposed at a location relatively closer to the display panel PNL, a distance between the view area and the active area can be reduced. The following description will be made with reference to the accompanying drawings.

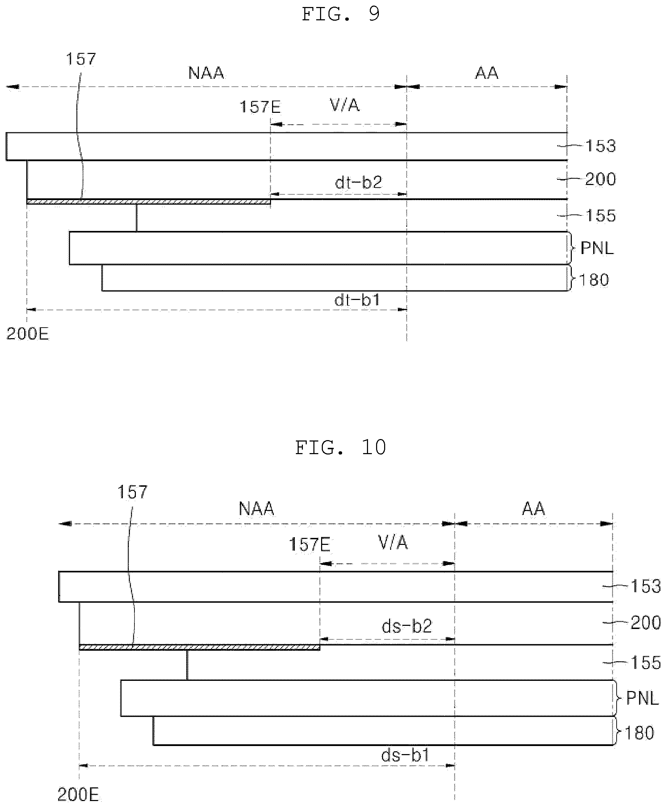

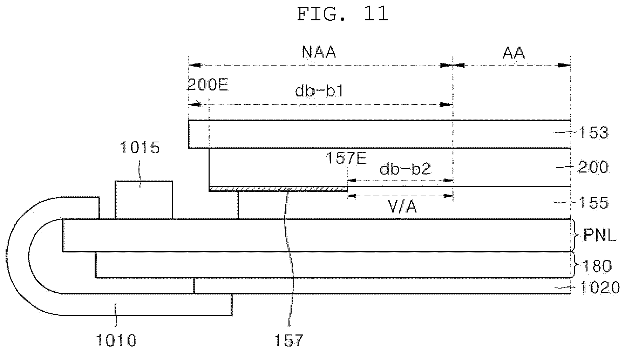

FIG. 9 is a cross-sectional view of the display apparatus shown in FIG. 1 along line 9-9 according to another example embodiment. FIG. 10 is a cross-sectional view of the display apparatus shown in FIG. 1 along line 10-10 according to another example embodiment. In addition, FIG. 11 is a cross-sectional view of the display apparatus shown in FIG. 1 along line 11-11 according to another example embodiment. In FIGS. 9 to 11, the display panel PNL and the back plate unit 180 are schematically shown for convenience of description.

Referring to FIGS. 9 to 11 and FIG. 1 together, the display apparatus 1000 may include the active area AA and the non-active area NAA surrounding the outside of the active area AA. The non-active area NAA may be second areas dt-b1, ds-b 1, and db-b 1 between the outermost portion 200E of the rigidity reinforcement layer 200 and the boundary of the active area AA. The second areas dt-b1, ds-b1, and db-b1 of the non-active area NAA may be the second area dt-b 1 (see FIG. 9) at the upper edge of the display panel PNL, the second area ds-b 1 (see FIG. 10) at the left and right edges of the display panel PNL, and the second area db-b 1 (see FIG. 11) at the lower edge of the display panel PNL.

The non-active area (NAA) may be located to overlap the view are V/A. The view area V/A may be an area visible to the user. The active area AA may be an area in which a video or image is displayed. The light blocking pattern 157 surrounding four outer edge portions of the rigidity reinforcement layer 200 may be disposed to form the view area V/A. The view area V/A may be located between an inner end portion 157E of the light blocking pattern 157 disposed close to the boundary of the active area AA and the boundary of the active area AA. For example, the view area V/A may have second separation distances dt-b2, ds-b2, and db-b2 between the inner end portion 157E of the light blocking pattern 157 and the boundary of the active area AA. The second separation distances dt-b2, ds-b2, and db-b2 of the view area V/A may be the second separation distance dt-b2 (see FIG. 9) at the upper edge of the display panel PNL, the second separation distance ds-b2 (see FIG. 10) at the left and right edges of the display panel PNL, and the second separation distance db-b2 (see FIG. 11) at the lower edge of the display panel PNL. For example, in a second direction of the base substrate 101, a length of the second area dt-b1 at the upper edge of the display panel PNL is equal to a sum of the second separation distance dt-b2 at the upper edge of the display panel PNL and a length of the light blocking pattern 157 (see FIG. 9). For example, in a first direction of the base substrate 101, a length of the second area ds-b 1 at the left and right edges of the display panel PNL is equal to the second separation distance ds-b2 at the left and right edges of the display panel PNL and a length of a length of the light blocking pattern 157 (see FIG. 10). For example, in a second direction of the base substrate 101, a length of the second area db-b1 at the lower edge of the display panel PNL is greater than a sum of the second separation distance db-b2 at the lower edge of the display panel PNL and a length of the light blocking pattern 157 (see FIG. 11). However, the present disclosure is not limited thereto.

As the rigidity reinforcement layer 200 is disposed at a location relatively closer to the display panel PNL, the second separation distances dt-b2, ds-b2, and db-b2 between the view area and the active area can be reduced more than the first separation distances dt-a2, ds-a2, and db-a2) between the view area and the active area when the cover substrate 160 is disposed on the uppermost portion of the display apparatus.

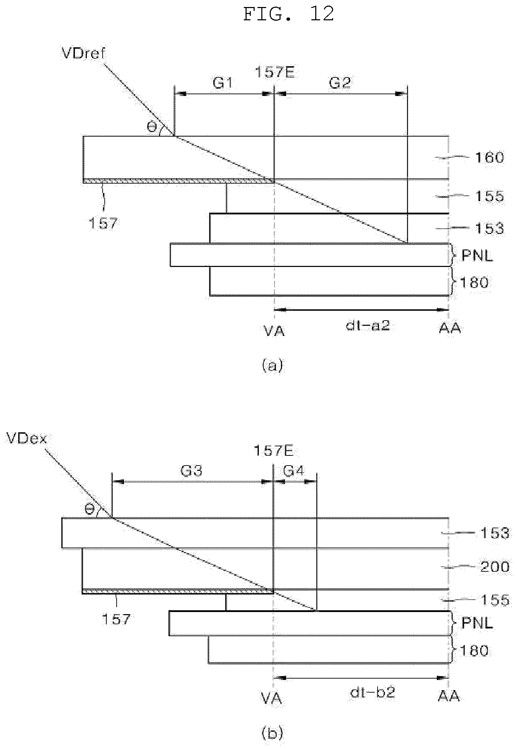

FIG. 12 is a view showing a viewing angle distance of example embodiments of the present disclosure. (a) of FIG. 12 shows a viewing angle distance of the display apparatus according to one example embodiment of the present disclosure. In addition, (b) of FIG. 12 shows a viewing angle distance of the display apparatus according to another example embodiment of the present disclosure.

Referring to FIG. 12, a viewing angle θ may be a viewing range in which there is no difference in luminance or color gamut between when viewing the display apparatus from the front of the display apparatus and when viewing the display apparatus after moving at an angle of 45 degrees from the front of the display apparatus.

Referring to (a) of FIG. 12, a viewing angle distance VDref of the display apparatus according to one example embodiment of the present disclosure may be the sum of a first gap G1 in which a viewing angle θ reaches from the inner end portion 157E of the light blocking pattern 157, and a second gap G2 between the inner end portion 157E of the light blocking pattern 157 and the surface of the display panel PNL. In addition, referring to (b) of FIG. 12, a viewing angle distance VDex of a display apparatus according to another example embodiment of the present disclosure may be the sum of a third gap G3 in which the viewing angle θ reaches from the inner end portion 157E of the light blocking pattern 157, and a fourth gap G4 between the inner end portion 157E of the light blocking pattern 157 and the surface of the display panel PNL.

In the display apparatus according to another example embodiment of the present disclosure, the rigidity reinforcement layer 200 may be disposed under the polarization layer 153. As the distance between the light blocking pattern 157 on the rigidity reinforcement layer 200 and the display panel PNL reduces, a distance of the fourth gap G4 between the light blocking pattern 157 and the display panel (PNL) may reduce more than the second gap G2. Therefore, the second separation distance dt-b2 in the view area V/A when the rigidity reinforcement layer 200 is disposed may be smaller than the first separation distance dt-a2 when the cover substrate 160 is disposed on the uppermost layer of the display apparatus.

The rigidity reinforcement layer 200 according to the example embodiment of the present disclosure may also be applied on the display panel PNL on which the touch sensing unit TS is not disposed.

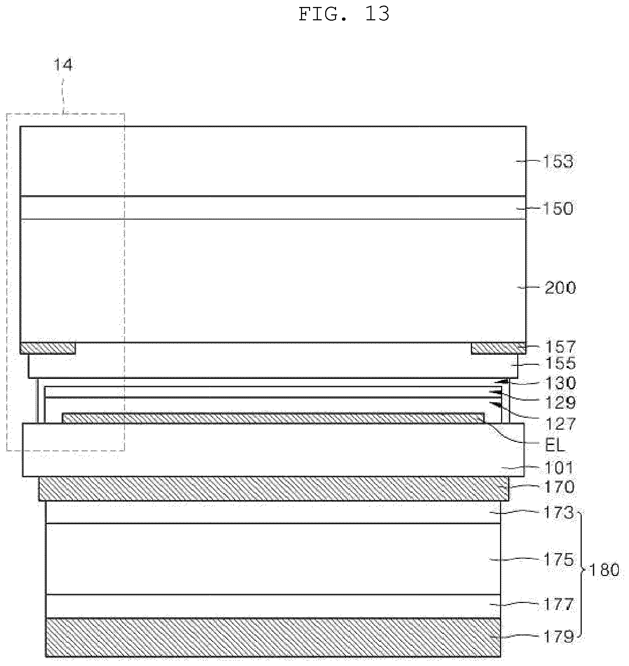

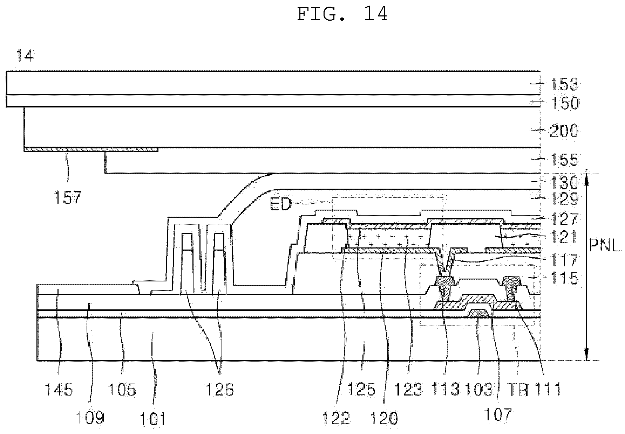

FIG. 13 is a cross-sectional view showing one side of the display apparatus of FIG. 1 according to another example embodiment. In addition, FIG. 14 is an enlarged cross-sectional view of area 14 in FIG. 13. In FIGS. 13 and 14, since the same components as those in FIGS. 8 and 9 have the same reference numerals, overlapping descriptions thereof will be omitted or briefly described, and different parts will be described.

Referring to FIGS. 13 and 14, the display apparatus according to another example embodiment of the present disclosure may have the rigidity reinforcement layer 200 disposed on the display panel PNL. The display panel PNL may include the light emitting element unit EL disposed on the base substrate 101 provided with the transistor TR. The light emitting element unit EL may include the organic light emitting diode ED including the first electrode 120, the organic light emitting layer 123, and the second electrode 125, and the bank 121 provided with the bank hole 122. The light emitting element unit EL may be sealed with the encapsulation layers 127, 129, and 130. The encapsulation layers 127, 129, and 130 may include the first encapsulation layer 127, the second encapsulation layer 129, and the third encapsulation layer 130. The back plate portion 180 may be disposed under the base substrate 101 of the display panel PNL to reinforce the rigidity of the display apparatus and mitigate the external impact. In addition, the back plate portion 180 may dissipate the heat generated inside the display panel PNL to the outside.

The base substrate 101 may include a dam structure 126 disposed between the active area and a pad area in which a pad electrode 145 is disposed. The dam structure 126 may include, for example, a structure in which the first dam formed coplanarly with the interlayer insulating layer 115 and the second dam formed coplanarly with the bank 121 are stacked vertically. The dam structure 126 may be covered with the first encapsulation layer 127 and the third encapsulation layer 130.

The rigidity reinforcement layer 200 may be disposed on the third encapsulation layer 130. The rigidity reinforcement layer 200 may be attached to the third encapsulation layer 130 of the display panel PNL through the optical adhesive member 155. The optical adhesive member 155 may include an optically clear adhesive film (OCA) or an optically clear adhesive resin (OCR). The optical adhesive member 155 may be disposed so that the rigidity reinforcement layer 200 is in contact with the entire area of the display panel PNL. As the rigidity reinforcement layer 200 is disposed in close contact with the entire area of the display panel PNL, it is possible to increase the rigidity of the display apparatus.

The light blocking pattern 157 may be disposed on the edge portion of the first surface of the rigidity reinforcement layer 200. The light blocking pattern 157 may have a closed loop shape surrounding four outer edge portions of the rigidity reinforcement layer 200.

The polarization layer 153 may be disposed on the second surface facing the first surface of the rigidity reinforcement layer 200 on which the light blocking pattern 157 is disposed. The polarization layer 153 may be bonded to the second surface of the rigidity reinforcement layer 200 through the first adhesive member 150. For example, the first adhesive member 150 may include a pressure-sensitive adhesive (PSA).

As the rigidity reinforcement layer 200 is attached to the display panel PNL instead of being disposed on the uppermost layer of the display apparatus, and as the polarization layer 153 is disposed on the uppermost layer of the display apparatus, the functional layers for surface treatment can be omitted. For example, the functional layers may include a multilayered structure such as an anti-fingerprint coating layer, an anti-reflection layer, and an anti-glare layer, but are not limited thereto.

By omitting the functional layers for surface treatment, it is possible to reduce the manufacturing costs of the display apparatus and reduce or eliminate the occurrence of defects. Therefore, the video or image quality of the display apparatus can be maintained. In addition, as the rigidity reinforcement layer 200 is disposed relatively closer to the display panel PNL to reduce the distance between the view area and the active area, it is possible to further increase the user's sense of immersion in the video or image.

A display apparatus according to an example embodiment of the present disclosure may include a display panel including an active area and a non-active area close to the active area, a light emitting element unit including a plurality of light emitting elements disposed on the active area of the display panel, a rigidity reinforcement layer disposed above the display panel, and a polarization layer disposed on the rigidity reinforcement layer.

The polarization layer may be disposed to protrude more than an outermost portion of the rigidity reinforcement layer, with respect to the display panel.

The polarization layer may be bonded to an upper surface of the rigidity reinforcement layer through an adhesive member.

In the display apparatus according to some example embodiments of the present disclosure, the substrate may further include a touch sensing unit disposed above the light emitting element unit and including a plurality of touch electrodes.

In the display apparatus according to some example embodiments of the present disclosure, the display apparatus may further include an optical adhesive member in contact with a back surface of the rigidity reinforcement layer and disposed in the entire area of the display panel.

In the display apparatus according to some example embodiments of the present disclosure, the optical adhesive member may include an optically clear adhesive resin.

In the display apparatus according to some example embodiments of the present disclosure, the rigidity reinforcement layer may contain a material in which a phase difference does not occur when light is transmitted and contain tempered glass, polycarbonate, or polymethyl methacrylate.

In the display apparatus according to some example embodiments of the present disclosure, the rigidity reinforcement layer may include the thickness ranging from 0.2 mm to 0.5 mm.

In the display apparatus according to some example embodiments of the present disclosure, the rigidity reinforcement layer may include a first surface facing the light emitting element unit, and a second surface facing the first surface and facing the polarization layer and, wherein the first surface of the rigidity reinforcement layer further include a light blocking pattern disposed on an edge portion.

The light blocking pattern may include a film mixed with an opaque pigment.

The opaque pigment may include carbon black or titanium black.

In the display apparatus according to some example embodiments of the present disclosure, the light blocking pattern may be located on the non-active area and include a closed loop shape surrounding four sides of the rigidity reinforcement layer.

In the display apparatus according to some example embodiments of the present disclosure, the light blocking pattern may be disposed to surround an upper edge, left edge, right edge, and lower edge of the display panel.

In the display apparatus according to some example embodiments of the present disclosure, the display apparatus may further include a view area located outside the active area and overlapping the non-active area, and the view area may include a separation distance between a boundary of the active area and an inner edge portion of the light blocking pattern.

In the display apparatus according to some example embodiments of the present disclosure, the separation distance may be reduced as the light blocking pattern disposed on the rigidity reinforcement layer is closer to the display panel.

In the display apparatus according to some example embodiments of the present disclosure, the light emitting element unit may include an organic light emitting element including a first electrode located on the active area of the display panel, an organic light emitting layer covering an exposed portion of the first electrode, and a second electrode disposed on the organic light emitting layer; and a bank covering an edge of the first electrode and including a bank hole exposing the exposed portion of the first electrode.

According to example embodiments of the present disclosure, it is possible to increase the rigidity of the display apparatus and increase durability thereof.

According to the example embodiments of the present disclosure, by arranging the adhesive member that covers the entire area of the display panel and arranging the rigidity reinforcement layer above the adhesive member, it is possible to prevent the adhesive member from acting as defect acting as foreign substance by being peeled from the films.

According to the example embodiments of the present disclosure, the rigidity reinforcement layer capable of increasing the rigidity of the display apparatus can be disposed under the polarization layer disposed on the uppermost portion of the display apparatus. Therefore, since the functional layer having a multilayered structure for surface treatment can be omitted, it is possible to implement the lightweight display apparatus, thereby reducing the weight of the overall product.

The effects of the present disclosure are not limited to the above-described effects, and other effects that are not mentioned will be able to be clearly understood by those skilled in the art from the following description.

Although the example embodiments of the present disclosure have been described in more detail with reference to the accompanying drawings, the present disclosure is not necessarily limited to these example embodiments, and various modifications may be carried out without departing from the technical spirit of the present disclosure. Therefore, the example embodiments disclosed in the present disclosure are not intended to limit the technical spirit of the present disclosure, but is intended to describe the same, and the scope of the technical spirit of the present disclosure is not limited by these example embodiments. Therefore, it should be understood that the above-described example embodiments are illustrative and not restrictive in all respects.

## Claims

1. A display apparatus (1000) comprising:
a display panel (PNL) including an active area (AA) and a non-active area (NAA) close to the active area (AA);
a light emitting element unit (EL) including a plurality of light emitting elements disposed on the active area (AA) of the display panel (PNL);
a rigidity reinforcement layer (200) disposed above the display panel (PNL); and
a polarization layer (153) disposed on the rigidity reinforcement layer (200).

2. The display apparatus (1000) of claim 1, wherein the polarization layer (153) is disposed to protrude more than an outermost portion of the rigidity reinforcement layer (200), with respect to the display panel (PNL).

3. The display apparatus (1000) of claim 1 or 2, wherein the polarization layer (153) is bonded to an upper surface of the rigidity reinforcement layer (200) through an adhesive member (150).

4. The display apparatus (1000) of any of claims 1 to 3, wherein the display panel (PNL) further includes a touch sensing unit (TS) disposed above the light emitting element unit (EL) and including a plurality of touch electrodes (135, 137).

5. The display apparatus (1000) of any of claims 1 to 4, further comprising an optical adhesive member (155) in contact with a back surface of the rigidity reinforcement layer (200) and disposed in the entire area of the display panel (PNL),
wherein, preferably, the optical adhesive member (155) includes an optically clear adhesive resin.

6. The display apparatus (1000) of any of claims 1 to 5, wherein the rigidity reinforcement layer (200) includes a material in which a phase difference does not occur when light is transmitted.

7. The display apparatus (1000) of any of claims 1 to 6, wherein the rigidity reinforcement layer (200) includes tempered glass, polycarbonate, or polymethyl methacrylate.

8. The display apparatus (1000) of any of claims 1 to 7, wherein the rigidity reinforcement layer (200) has the thickness ranging from 0.2 mm to 0.5 mm.

9. The display apparatus (1000) of any of claims 1 to 8, wherein the rigidity reinforcement layer (200) includes: a first surface facing the light emitting element unit (EL); and
a second surface opposite to the first surface and facing the polarization layer (153), and
wherein the first surface of the rigidity reinforcement layer (200) further includes a light blocking pattern (157) disposed on an edge portion.

10. The display apparatus (1000) of claim 9, wherein the light blocking pattern (157) includes a film mixed with an opaque pigment,
wherein, preferably, the opaque pigment includes carbon black or titanium black.

11. The display apparatus (1000) of claims 9 or 10, wherein the light blocking pattern (157) is located on the non-active area (NAA) and includes a closed loop shape surrounding four sides of the rigidity reinforcement layer (200).

12. The display apparatus (1000) of claim 11, wherein the light blocking pattern (157) surrounds an upper edge, left edge, right edge, and lower edge of the display panel (PNL).

13. The display apparatus (1000) of any of claims 9 to 12, further comprising a view area (V/A) located outside the active area (AA) and overlapping the non-active area (NAA),
wherein the view area (V/A) includes a separation distance between a boundary of the active area (AA) and an inner edge portion of the light blocking pattern (157).

14. The display apparatus (1000) of claim 13, wherein the separation distance reduces as the light blocking pattern (157) disposed on the rigidity reinforcement layer (200) is closer to the display panel (PNL).

15. The display apparatus (1000) of any of claims 1 to 14, wherein the light emitting element unit (EL) includes:
an organic light emitting element including a first electrode (120) located on the active area (AA) of the display panel (PNL), an organic light emitting layer (123) covering an exposed portion of the first electrode (120), and a second electrode (125) disposed on the organic light emitting layer (123); and
a bank (121) covering an edge of the first electrode (120) and including a bank hole exposing the exposed portion of the first electrode (120).
